# DEMANDE DE BREVET EUROPEEN

(11) **EP 0 892 439 A1**
(43) Date de publication de la demande: **20.01.1999**
(21) Numéro de dépôt: 97114703.8
(22) Date de dépôt: 25.08.1997
(51) Int. Cl.: H01L 27/146, G01R 31/26

(54) **Photocapteur intégré comprenant un circuit de test**

(30) Priorité: 15.07.1997 CH 1728/97
(71) Demandeur: EM Microelectronic-Marin SA, 2074 Marin (CH)
(72) Inventeur: Grandjean, André, 2088 Cressier (CH)
(74) Mandataire: Balsters, Robert

(57) **Abrégé**

Ce photocapteur comprend un réseau (R) de cellules (...., Cn-1, Cn, Cn+1, Cn+2,....) comportant chacune une diode (PH) et un circuit d'exploitation (CE) pour permettre le transfert d'un signal de mesure issu de la cellule (...., Cn-1, Cn, Cn+1, Cn+2,....) et dû à l'éclairement de celle-ci, à une sortie commune (SC) du photocapteur. Un signal d'adressage permet de connecter séquentiellement toutes les cellules à la sortie commune.

Selon l'invention, chaque cellule comporte également une région conductrice intégrée formant avec la diode une capacité de test (CPT) couplée à la capacité parasite (CP).

En vue de tester les diodes dans l'obscurité, il comprend également des moyens (H, CT, M) intégrés sur la puce (P) pour, en synchronisme avec l'application sélective dudit signal d'adressage, appliquer à la capacité de test (CPT) une impulsion de test provoquant un transfert de charges de la capacité de test CPT) vers la capacité parasite (CP). Ceci simule l'éclairement de la diode et engendre sur la sortie commune (SC), à la place du signal de mesure, un signal représentatif du bon fonctionnement de la cellule adressée.

## Description

La présente invention est relative aux capteurs photoélectriques comportant un réseau de cellules photosensibles afin de permettre l'analyse d'informations contenues dans un signal lumineux qui frappe le capteur.

Un type de photocapteur de ce genre actuellement mis sur le marché est réalisé sur une puce sous la forme d'un circuit intégré, chaque cellule du réseau comportant une photodiode et un circuit d'exploitation du signal fourni par la photodiode. Ce circuit d'exploitation est destiné à produire un signal de sortie oui peut être transféré à une sortie commune du capteur, grâce à un dispositif d'adressage séquentiel connecté à toutes les cellules et capable, durant des cycles répétitifs de travail, de transférer un à un tous les signaux de sortie des circuits d'exploitation sur la sortie commune à l'aide d'un signal d'horloge.

La fabrication d'un tel photocapteur sous forme de puce de circuit intégré se fait en général sur une plaquette de silicium sur laquelle par des procédés de lithographie habituels dans l'industrie des semi-conducteurs, on peut en obtenir simultanément un très grand nombre d'identiques, tous les capteurs comportant leur propre réseau de cellules photosensibles.

Pour vérifier le bon fonctionnement de chaque capteur après la fabrication, il est de pratique courante de faire subir au circuit intégré un test qui implique notamment le contrôle des photodiodes de chaque cellule du réseau de chaque capteur se trouvant sur la plaquette de silicium.

Pour effectuer le test, les puces formant capteurs d'une même plaquette, sont successivement amenées dans un poste classique de contrôle de circuits intégrés auquel on doit adjoindre une source indépendante de lumière d'une intensité calibrée. Cette source doit être soigneusement positionnée en face de chaque capteur pour qu'elle puisse l'éclairer convenablement au moment du test.

Ainsi, au cours du test, chaque capteur est soumis à une séquence d'exploration de toutes les cellules, le signal engendré à la sortie de chacune d'elles par sa photodiode étant prélevé sur la sortie commune du capteur pour être confronté à un seuil de valeur prédéterminée. Si un signal ainsi prélevé correspondant à une diode déterminée demeure en dessous du seuil, la cellule est déclarée défectueuse. Le capteur lui-même est globalement déclaré inapte si le nombre de cellules défectueuses dépasse un valeur prédéterminée.

Cette procédure de test présente un inconvénient important en ce qu'elle nécessite un poste de contrôle de puces spécialement aménagé devant être constitué à partir d'un poste de contrôle habituel en le dotant d'une source lumineuse adéquate. Cependant, il est très délicat de positionner la source lumineuse correctement dans le poste de contrôle par rapport aux circuits intégrés à tester de manière à obtenir un éclairement égal pour tous les capteurs successivement testés et également pour toutes les cellules d'un même capteur, un écart même faible par rapport à la position nominale pouvant entraîner une décision d'inaptitude, alors que le défaut peut ne pas être inhérent à la puce mais au positionnement instantané de la source lumineuse par rapport au capteur en question.

L'invention a pour but de fournir un photocapteur dont la procédure de test peut être mise en oeuvre sans modifications notables du poste de test et moyennant un risque faible, voire nul de rejet en raison d'une erreur de mesure durant le test. En outre, l'invention vise à fournir un photocapteur dont le circuit de test fait partie intégrante de la puce sur laquelle il est réalisé ("circuit on-chip")

L'invention a donc pour objet un photocapteur du type réalisé sous la forme d'une puce de circuit intégré comprenant un réseau de cellules comportant chacune un composant photosensible et un circuit d'exploitation connecté à ce composant pour permettre le transfert d'un signal de mesure issu de la cellule et dû à l'éclairement de celle-ci, à une sortie commune du photocapteur sous l'action d'un signal d'adressage permettant de connecter sélectivement et séquentiellement toutes les cellules à ladite sortie commune, ledit composant photosensible présentant intrinsèquement une capacité parasite propre, caractérisé en ce que
- chaque cellule comporte également une région conductrice intégrée formant avec ledit composant photosensible une capacité de test qui est couplée à ladite capacité parasite, et
- en ce qu'en vue de tester lesdits composants photosensibles dans l'obscurité, il comprend également des moyens intégrés sur la puce pour, en synchronisme avec l'application sélective dudit signal d'adressage, appliquer à ladite capacité de test de chaque composant une impulsion de test provoquant un transfert d'une quantité prédéterminée de charges de ladite capacité de test vers ladite capacité parasite du composant, ladite quantité prédéterminée équivalant à celle avec laquelle cette capacité parasite serait chargée si le photocapteur était éclairé avec une intensité prédéterminée, et engendrant ainsi sur ladite sortie commune, à la place dudit signal de mesure, un signal représentatif du fonctionnement de la cellule respectivement adressée.

Ainsi, grâce à l'invention, il devient possible de simuler le fonctionnement de chaque composant photosensible sans avoir à lui fournir une quantité de lumière précise. Au contraire, les photocapteurs peuvent être contrôlés dans l'obscurité, à l'écart de toute source lumineuse. Tout travail de réglage et toute source d'erreur de mesure à cet égard sont donc éliminés

L'invention a également pour objet un procédé de fabrication d'un photocapteur tel qu'il vient d'être défini, caractérisé en ce qu'il consiste, pendant les étapes de fabrication menant à la création de sa structure, à réaliser en supplément :
- un amplificateur de test commun à toutes les cellules,
- au-dessus du composant photosensible de chacune de ses cellules une région conductrice de dimensions prédéterminées, et
- un maillage de conducteurs de test tous connectés les uns aux autres, auxdites régions de test et à la sortie dudit amplificateur de test.

D'autres caractéristiques et avantages de l'invention apparaîtront au cours de la description qui va suivre, donnée uniquement à titre d'exemple et faite en se référant aux dessins annexés sur lesquels :
- la figure 1 est un schéma très simplifié d'un photocapteur selon l'invention, le schéma représentant notamment des moyens de test des cellules du photocapteur; et
- la figure 2 est un diagramme représentant la topographie d'une partie d'un photocapteur selon l'invention équipé de ses moyens de test.

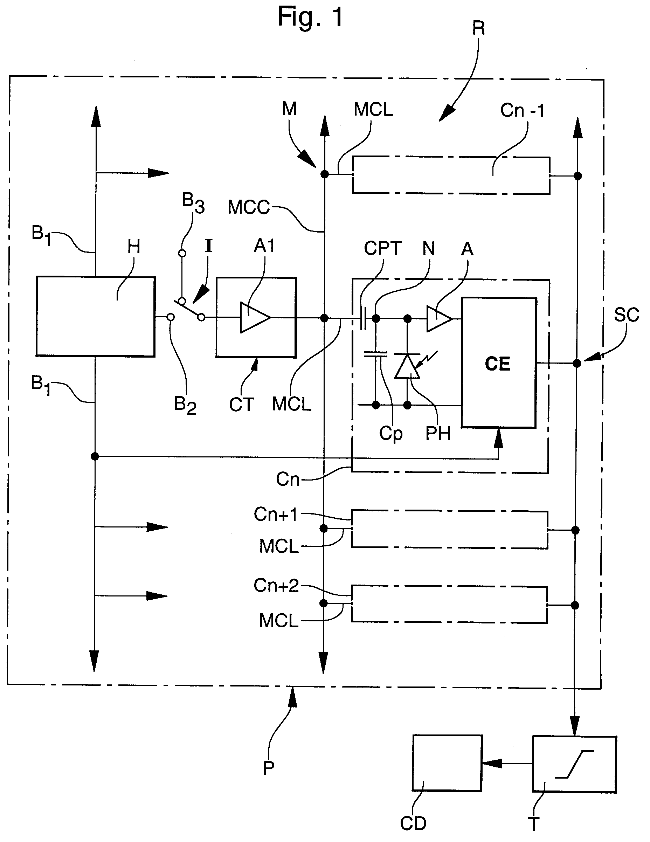

La figure 1 représente un schéma très simplifié d'une puce P présentant un réseau R de cellules photosensibles ....Cn-1, Cn, Cn+1, Cn+2.... qui peuvent être une centaine au total par exemple et être disposées en rangées et colonnes, la figure 1 n'en représentant qu'une seule colonne. Le réseau peut avoir toute forme voulue, un agencement avantageux étant celle dans laquelle tout le réseau s'inscrit dans un cercle.

Chaque cellule ....Cn-1, Cn, Cn+1, Cn+2.... (désignée ci-après par la référence Cn pour simplifier) comporte une photodiode PH qui est raccordée à un amplificateur A dont la sortie est connectée à un circuit d'exploitation CE. Ce dernier est chargé de traiter convenablement le signal de la photodiode et assure sous la commande d'un signal d'horloge, la transmission de ce signal de photodiode vers sa sortie qui est raccordée en commun avec toutes les sorties équivalentes des autres circuits d'exploitation des cellules du réseau à une sortie commune SC du photocapteur.

Un exemple d'un capteur photosensible équipé de cellules de ce type a été décrit dans un article de Xavier Arreguit et al. dans IEEE Journal of Solid State Circuits, Vol. 31, N° 12, Décembre 1996, auquel on pourra se référer pour plus de détail. Dans ce cas, le photocapteur est spécialement destiné à être utilisé comme détecteur de mouvement, en particulier pour une souris d'ordinateur à commande par une boule. Cependant, il convient de souligner que la présente invention peut être appliquée à tout photocapteur intégré sur une puce et comportant un réseau de cellules équipées chacune d'une photodiode ou un composant photosensible équivalent.

La puce de circuit intégré P est de préférence fabriquée simultanément avec d'autres puces identiques sur une plaquette de silicium, par des techniques de photolithographie habituelles, bien connues des spécialistes.

Outre le réseau R de cellules individuelles Cn, la puce P comporte également un circuit d'horloge H prévu en commun pour toutes les cellules.

On voit que le circuit d'horloge H est connecté par une borne de sortie B1 au circuit d'exploitation CE de toutes les cellules de la puce P. Cet agencement permet, de façon connue en soi et comme décrit en détail dans l'article précité, d'envoyer le signal d'horloge en tant que signal d'adressage et selon une procédure d'exploration cyclique, à toutes les cellules, les unes après les autres, afin que leur circuit d'exploitation CE puisse délivrer, à son tour dans le cycle d'adressage, un signal utile sur la sortie commune SC pendant que la cellule correspondante est activée.

Suivant l'invention, le photocapteur comporte également un circuit de test CT prévu en commun pour toutes les cellules. Il comporte un amplificateur A1 de mise en forme d'impulsions qui peut recevoir le signal d'horloge d'une borne B2 du circuit d'horloge H.

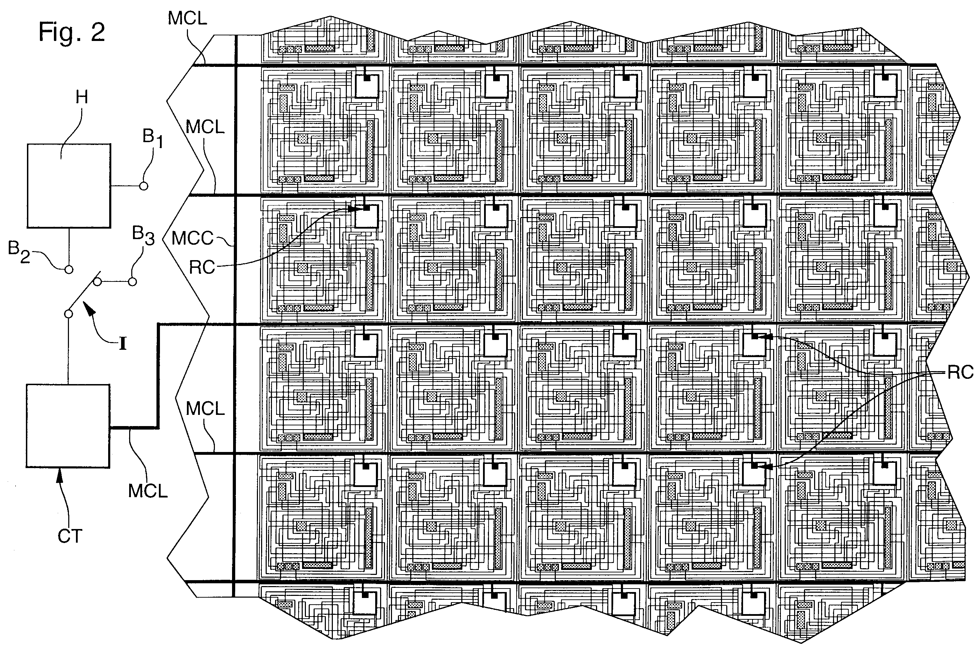

La sortie de l'amplificateur A1 est reliée à un maillage M de conducteurs de test comportant, dans le présent exemple, un conducteur de colonne MCC auquel sont raccordés des conducteurs de ligne MCL desservant chacun toutes les cellules d'une rangée du réseau R. Le conducteur de colonne MCC court le long de l'un des bords du réseau de cellules, tandis que les conducteurs de ligne MCL s'étendant respectivement le long de toutes les lignes de cellules du réseau du photocapteur (voir également la figure 2). Tous les conducteurs du maillage M étant connectés les uns aux autres, toutes les cellules du réseau sont reliées à la sortie de l'amplificateur de test A1.

Sur le schéma de la figure 1, on a représenté en parallèle sur la diode photosensible PH, une capacité parasite CP qui est inhérente à la structure de chaque cellule et à celui du circuit intégré de la puce dont est constitué le photocapteur. Cette capacité parasite est normalement considérée comme un élément gênant, mais on verra ci-après que l'invention en fait un usage avantageux sans compromettre le fonctionnement normal du photocapteur.

Selon un autre aspect important de l'invention, le noeud commun N entre la diode PH, l'entrée de l'amplificateur A et la capacité parasite CP de la diode est connecté au maillage de conducteurs M, c'est à dire à la sortie de l'amplificateur A1, par l'intermédiaire d'une capacité de test CPT.

Celle-ci est formée par une région conductrice RC prévue au-dessus de la diode photosensible PH de chaque cellule du réseau et obtenue par lithographie en fin de fabrication de la puce, par exemple en même temps que le maillage de conducteurs M. Les régions RC formant capacité de test sont clairement visibles sur la figure 2. La dimension de chaque région conductrice RC est déterminée de telle façon que la capacité qu'elle forme avec la diode PH est à peu 1% de la capacité parasite CP de celle-ci. Pratiquement, la valeur de la capacité de test CPT peut être de quelques femtofarads (10⁻¹⁵ F).

On notera que l'entrée de l'amplificateur A1 est connectée à un inverseur I qui permet de relier cette entrée sélectivement à la sortie B2 du circuit d'horloge H pour l'exécution du test et à une borne de tension B3 permettant, pendant le fonctionnement normal du photocapteur, de neutraliser l'amplificateur A1 et par suite le maillage de conducteurs M et les régions conductrices RC qui y sont connectées. C'est cette position de l'interrupteur I qui est représentée sur la figure 1. Bien entendu, l'interrupteur I peut être réalisé sous forme d'un transistor intégré faisant partie du circuit de test CT. Par ailleurs, on comprend que ce transistor ainsi que la borne B3, peuvent être remplacés par des plots de connexion externes ("bondpad") comprenant une résistance de rappel à 0 volt.

L'interrupteur I étant commandé de manière à connecter le circuit d'horloge H à l'amplificateur A1, le test du photocapteur peut être effectué sur un poste de contrôle classique pour circuits intégrés en procèdent à l'exploration séquentielle de toutes les cellules comme si on faisait une mesure de la lumière frappant le photocapteur. Cependant, le test est effectué dans l'obscurité de manière que les cellules Cn ne puissent produire un signal électrique dû à un éventuel éclairement.

Ainsi, lorsque les cellules Cn d'un photocapteur déterminé se trouvant sur une plaquette de circuit intégré placée dans le poste de contrôle, sont successivement adressées par le système d'adressage du photocapteur, l'impulsion d'horloge, amplifiée et mise en forme par l'amplificateur A1, engendre à la sortie de celui-ci une impulsion de test calibrée qui injecte par l'intermédiaire de la capacité de test CPT une quantité déterminée de charges dans la capacité parasite CP de la cellule Cn adressée à l'instant considéré. Le rapport des valeurs des deux capacités et le calibrage de l'impulsion de test sont déterminés de telle façon que la quantité de charges sur la capacité parasite corresponde à une utilisation du photocapteur sous un éclairement nominal rencontré lorsque le photocapteur est utilisé normalement.

Le signal ainsi engendré par une cellule adressée est transféré sur la sortie commune SC.

Cette dernière peut être raccordée à un circuit de seuil T pour vérifier si la diode PH de la cellule Cn adressée fonctionne correctement. La diode en question est déclarée défectueuse, si le signal sur la sortie commune SC n'arrive pas à franchir le seuil. Un compteur de défaillances CD branché à la sortie du circuit de seuil T permettra de dresser le bilan de toutes les mesures ainsi effectuées au cours d'un test de photocapteur. On peut ainsi d'en évaluer le bon fonctionnement, un nombre de cellules défaillantes prédéterminé pouvant entraîner la mise au rebut du photocapteur en question.

On constate ainsi, que le test des photocapteurs ne nécessite dans le poste de contrôle aucun éclairement c'est-à-dire aucun réglage d'une source lumineuse par rapport à la plaquette de circuit imprimée sur laquelle il a été fabriqué.

Il convient de noter que le test de bon fonctionnement des photocapteurs peut être réalisé sur une plaquette comportant un grand nombre de puces successivement soumises au test. Mais on peut également envisager d'effectuer celui-ci sur des puces déjà séparées d'une plaquette de circuit intégré, par exemple en les montant sur un film qui est amené à passer dans le poste de contrôle, comme cela est bien connu dans la technique des semi-conducteurs.

## Revendications

1. Photocapteur du type réalisé sous la forme d'une puce (P) de circuit intégré comprenant un réseau (R) de cellules (...., Cn-1, Cn, Cn+1, Cn+2,....) comportant chacune un composant photosensible (PH) et un circuit d'exploitation (CE) connecté à ce composant (PH) pour permettre le transfert d'un signal de mesure issu de la cellule (...., Cn-1, Cn, Cn+1, Cn+2,....) et dû à l'éclairement de celle-ci, à une sortie commune (SC) du photocapteur sous l'action d'un signal d'adressage permettant de connecter sélectivement et séquentiellement toutes les cellules (...., Cn-1, Cn, Cn+1, Cn+2,....) à ladite sortie commune, ledit composant photosensible (PH) présentant intrinsèquement une capacité parasite propre (CP) , caractérisé en ce que
- chaque cellule (...., Cn-1, Cn, Cn+1, Cn+2,....) comporte également une région conductrice (RC) intégrée formant avec ledit composant photosensible (PH) une capacité de test (CPT) qui est couplée à ladite capacité parasite (CP), et
- en ce qu'en vue de tester lesdits composants photosensibles (PH) dans l'obscurité, il comprend également des moyens (H, CT, M) intégrés sur la puce (P) pour, en synchronisme avec l'application sélective dudit signal d'adressage, appliquer à ladite capacité de test (CPT) de chaque composant une impulsion de test provoquant un transfert d'une quantité prédéterminée de charges de ladite capacité de test (CPT) vers ladite capacité parasite (CP) du composant (PH), ladite quantité prédéterminée équivalant à celle avec laquelle cette capacité parasite (CP) serait chargée si le photocapteur était éclairé avec une intensité prédéterminée, et engendrant ainsi sur ladite sortie commune, à la place dudit signal de mesure, un signal représentatif du fonctionnement de la cellule (...., Cn-1, Cn, Cn+1, Cn+2,...) respectivement adressée.

2. Photocapteur suivant la revendication 1, caractérisé en ce que les régions conductrices (RC) de toutes les cellules (...., Cn-1, Cn, Cn+1, Cn+2,....) sont reliées à un maillage (M) formé de conducteurs (MCC, MCL) intégrés sur ladite puce (P) et tous connectés à la sortie d'un amplificateur de test commun (A1) dont l'entrée est connectée pour pouvoir recevoir en synchronisme avec ledit signal d'adressage, une succession d'impulsions qui à la sortie de l'amplificateur de test (A1), engendrent les impulsions de test pour les cellules (...., Cn-1, Cn, Cn+1, Cn+2,....) testées les unes après les autres.

3. Photocapteur suivant la revendication 2, caractérisé en ce qu'il comprend également, intégré sur ladite puce (P), un circuit d'horloge (H), capable d'engendrer ledit signal d'adressage en synchronisme avec lesdits impulsions de test.

4. Photocapteur selon la revendication 3, caractérisé en ce que ledit amplificateur de test (A1) est connecté audit circuit d'horloge (H) par l'intermédiaire d'un sélecteur (I) destiné à établir la connexion entre ledit circuit d'horloge (H) et ledit amplificateur de test (A1) uniquement lorsqu'un test doit être effectué.

5. Photocapteur suivant la revendication 4, caractérisé en ce que ledit sélecteur (I) est connecté pour, en régime de fonctionnement normal du photocapteur, permettre l'application audit amplificateur de test (A1) d'un signal neutre pour neutraliser ledit maillage (M) de conducteurs (MCC, MCL) et lesdites régions conductrices (RC).

6. Photocapteur suivant l'une quelconque des revendications 1 à 5, caractérisé en ce que ledit composant photosensible (PH) est une diode et en ce que ladite région conductrice (RC) constitue avec ladite diode une capacité de test (CPT) dont la valeur est d'environ 1% de celle de la capacité parasite (CP) de ladite diode (PH).

7. Procédé de fabrication d'un photocapteur suivant l'une quelconque des revendications 1 à 6, caractérisé en ce qu'il consiste, pendant les étapes de fabrication menant à la création de sa structure, à réaliser en supplément :
- un amplificateur de test (A1) commun à toutes les cellules (...., Cn-1, Cn, Cn+1, Cn+2,....),
- au-dessus du composant photosensible (PH) de chacune de ses cellules (...., Cn-1, Cn, Cn+1, Cn+2,....), une région conductrice (RC) de dimensions prédéterminées, et
- un maillage (M) de conducteurs de test (MCC, MCL), tous connectés les uns aux autres, auxdites régions de test et à la sortie dudit amplificateur de test (A1).
